(19) Europäisches Patentamt
European Patent Office
Office européen des brevets

(11) EP 0 605 707 B1

(12) EUROPEAN PATENT SPECIFICATION

(45) Date of publication and mention
of the grant of the patent:
**18.12.1996 Bulletin 1996/51**

(21) Application number: **93917289.6**

(22) Date of filing: **23.07.1993**

(51) Int Cl.$^6$: **H03K 3/037**

(86) International application number:
**PCT/US93/06814**

(87) International publication number:
**WO 94/03974 (17.02.1994 Gazette 1994/05)**

(54) **LOGIC CELL WHICH CAN BE CONFIGURED AS A TRANSPARENT LATCH**

ALS TRANSPARENTES LATCH KONFIGURIERBARE LOGIKZELLE

CELLULE LOGIQUE POUVANT ETRE CONFIGUREE SOUS FORME DE VERROU TRANSPARENT

(84) Designated Contracting States:
**DE FR GB**

(30) Priority: **29.07.1992 US 922285**

(43) Date of publication of application:
**13.07.1994 Bulletin 1994/28**

(73) Proprietor: **Xilinx, Inc.**
**San Jose, California 95124-3400 (US)**

(72) Inventor: **GOETTING, F., Erich**
**Cupertino, CA 95014 (US)**

(74) Representative: **W.P. THOMPSON & CO.**
**Celcon House**
**289-293 High Holborn**
**London WC1V 7HU (GB)**

(56) References cited:
**EP-A- 0 219 907**

- **J. F. WAKERLY 'Digital Design Principles and Practices' 1990 , PRENTICE HALL , ENGLEWOOD CLIFFS, NEW JERSEY, US cited in the application**
- **ELECTRONIC DESIGN vol. 35, no. 7, 19 March 1987, HASBROUCK HEIGHTS, NEW JERSEY US , pages 151 - 154, 156 , XP000211521 D. E. SMITH ET AL. 'Regain Lost I/O Ports with Erasable PLDs'**
- **IEEE JOURNAL OF SOLID-STATE CIRCUITS vol. 23, no. 2, April 1988, NEW YORK US pages 323 - 328 R. CORDELL 'A 45-Mbit/s CMOS VLSI Digital Phase Aligner'**

## Description

### FIELD OF THE INVENTION

The invention relates to programmable logic devices formed in integrated circuit chips. More particularly, the invention relates to logic cells which are part of field programmable gate array chips.

### BACKGROUND OF THE INVENTION

In integrated circuit devices, sequential functions such as flip flops are typically formed from latches. A latch may be formed as a two-part structure, one part for data input and one part for feeding back the data to form the latch. A clock signal controls whether data from a data input terminal will be forwarded to the output or whether the output signal will be provided as input and forwarded, thus forming the latch. A transparent latch according to the preamble portion of the independent claim 1 is known from ELECTRONIC DESIGN, vol. 35, no. 7, 19 March 1987, pages 151-154, 156; D.E. SMITH et al.: "Regain Lost I/O Ports with Erasable PLD'S". A problem called the static ones hazard, namely registering a logical 0 when data input is logical 1, can occur with a latch of this logic structure when the circuit is entering the latch mode. This occurs because a switching latch enable signal can cause a logical 0 signal to appear at the output of the data input section before the logical 1 data has been captured into the feedback section. Thus a logical 0 is erroneously captured. Such an error must of course be avoided.

One prior art method of avoiding the static ones hazard is to add an extra gate. John F. Wakerly in a textbook entitled "Digital Design Principles and Practices" published in 1990 by Prentice Hall, Inc. describes the static one's hazard at pages 413-415, and shows a circuit having a gate which independently receives the data input signal. This extra gate does successfully avoid the static one's hazard. However, the extra gate adds silicon area and also slows the response time, and for those reasons is undesirable. It is preferable to avoid the static one's hazard without increasing silicon area or reducing performance. A corresponding approach is set forth in EP-A-0 219 907, wherein the switching thresholds of the gate inputs receiving the clock signal are chosen so that the gates respond successively instead of (substantially) simultaneously to the clock signal.

According to the present invention there is provided a transparent latch comprising:

a data input section which receives a data input signal and a first internal clock signal, and generates a data output signal;
a feedback section which receives a feedback input signal and a second internal clock signal, and generates a feedback output signal; and

an output section which generates an output signal from signals provided by said data input section and said feedback section, said output signal serving as said feedback signal;

characterised by

a programmable input inverter stage comprising:
a first optional inverter for receiving an external clock signal and providing said first internal clock signal, and being either configured to pass the said external clock signal through to said data input section or configured as an inverter passing the complement of said external clock signal to said data input section; and
a second optional inverter for receiving said external clock signal and providing said second internal clock signal, and being either configured to pass the said external clock signal through to said feedback section or configured as an inverter passing the complement of said external clock signal to said feedback section;
said programmable input inverter stage being programmable such that one of said first and second optional inverters is configured as an inverter and the other of said first and second optional inverters is configured to pass said external clock signal through;
said first and second optional inverters having a first trip point, and said data input section and said feedback section comprising logic gates having a second trip point lower than said first trip point.

Hence according to the present invention, the static ones hazard can be avoided by controlling trip points in the gates of the cell so that the cell implements a make-before-break transition. The trip point is the input voltage at which the output voltage changes between logical 0 and logical 1, and may be defined for an inverter as that voltage at which the input voltage is equal to the output voltage.

Clock input signals are applied to the data input section and the feedback section, one clock signal being inverted and the other non-inverted. Logic gates in each part combine the clock signal and the input or feedback signal to generate an intermediate output. Intermediate outputs of the two sections are combined in another logic gate to generate a latch output signal.

If the inverter which receives the clock signal has a relatively low trip point and the logic gate which receives the clock signal has a relatively high trip point, a static ones error is found to occur. If the inverter has a higher trip point and the logic gate has a lower trip point, the Q output signal is found to properly follow the D input signal through the positive and negative shifts of the clock signal. By manufacturing inverters at the gate inputs to have higher trip points than trip points of the logic gates which receive the clock signal and the input data or the feedback data, the static ones problem is avoided. This combination of trip points produces correct results for both a fast-changing clock signal and a slow-changing clock signal.

BRIEF DESCRIPTION OF THE DRAWINGS

Fig. 1 shows a logic cell which can implement the static latch of the present invention.

Figs. 2A and 2B show a latch with clear and its implementation using the cell of Fig. 1.

Figs. 2C shows the equivalent circuit formed by the circuit of Fig. 2B.

Figs. 2D and 2E show a latch with clear having the opposite clock polarity from that of Figs. 2A-2C.

Fig. 2F shows the equivalent circuit formed by the circuit of Fig. 2E.

Fig. 3A shows a timing diagram of signals in the circuit of Figs 2A-2C, illustrating a static-ones problem.

Fig. 3B shows a timing diagram which avoids the static ones problem of Fig. 3A by properly controlling the trip points of the inverters and NAND gates of Fig. 1.

DETAILED DESCRIPTION OF THE INVENTION

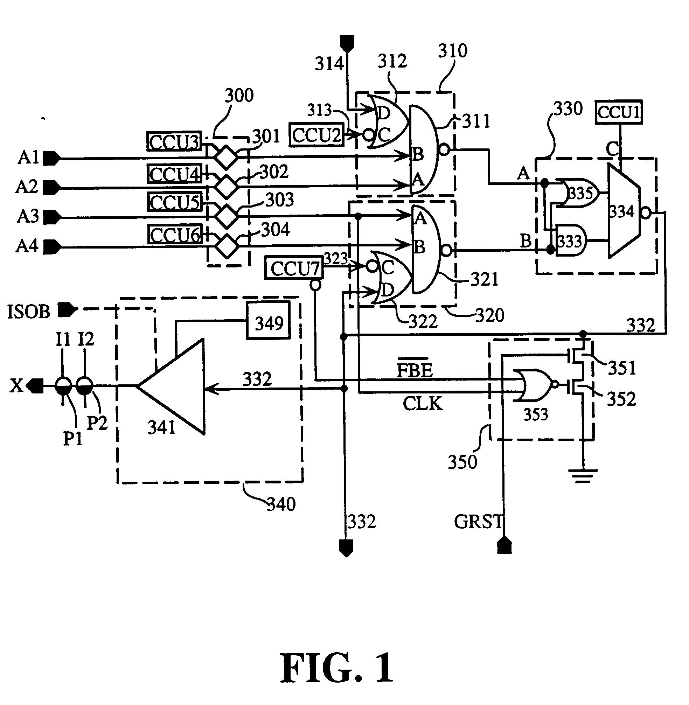

The logic cell of Figure 1 comprises four major sections:

(1) a programmable input inverter stage 300,
(2) a cascade-in first combinational stage 310,
(3) a feedback first combinational stage 320, and
(4) a second combinational stage 330.

Overview of the Four Sections of Fig. 1

Input buffer stage 300 comprises four input buffers 301 through 304, each of which can be inverting or non-inverting as selected by the user.

Cascade-in first combinational stage 310 comprises a 3-input NAND gate 311 and a 2-input OR gate 312. OR gate 312 receives a cascade enable control input 313 and a cascade input 314 from an adjacent cell. OR gate 312 provides input to NAND gate 311. Also provided as input to NAND gate 311 are outputs from selectively inverting input buffers 301 and 302.

Feedback first combinational stage 320 also comprises a three-input NAND gate 321 fed by output signals from selectively inverting input buffers 303 and 304. NAND gate 321 further receives input from OR gate 322 which receives on one of its input terminals a feedback signal 332 and on another input terminal a feedback enable control input 323.

Second combinational stage 330 can be programmed to provide a NAND or a NOR function of outputs from the cascade combinational stages 310 and 320. Second combinational stage 330 provides an output signal 332 which can be fed back by OR gate 322 to AND gate 321, can further be provided as a cascade OUT signal which becomes a cascade IN signal to an adjacent cell, and which is provided to output driver stage 340, where it can be driven onto the interconnect structure and used as input to other cells.

Latch with Clear and Solution to Static Ones Problem

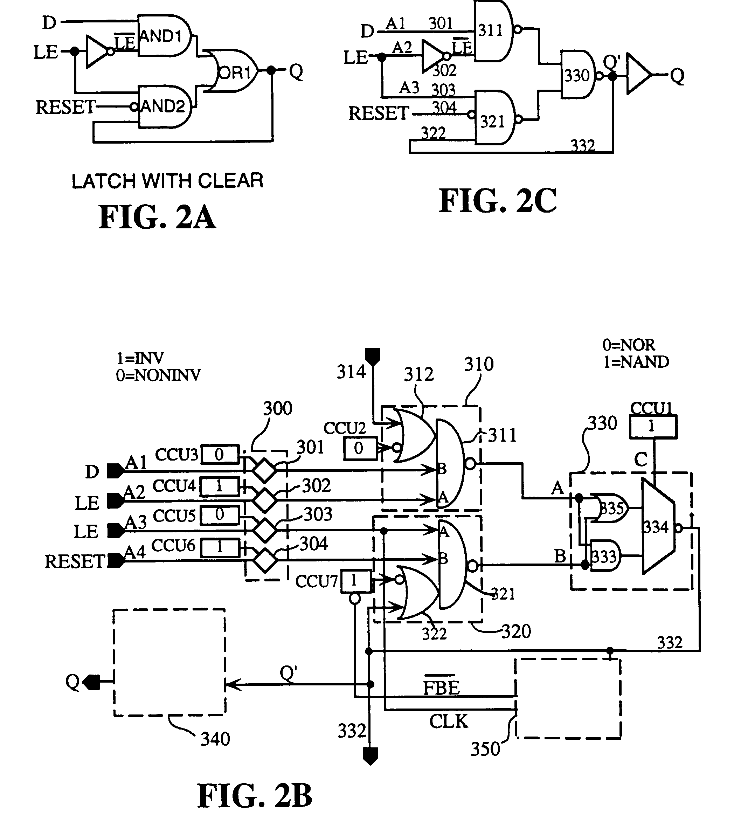

Fig. 2A shows a latch with clear which can be implemented by the circuit of Fig. 1. Fig. 1 can be configured several ways to implement the static latch, however only one method will be described. As shown in Fig. 2B, the D (data) input of Fig. 2A is provided on line A1 of Fig. 1. Latch enable signal LE of Fig. 2A is applied to lines A2 and A3. Optional inverter 302 is set to be inverting and optional inverter 303 is set to be noninverting. The Reset input of Fig. 2A is provided to line A4. Feedback control unit CCU7 stores a logical 1 which enables the feedback path by applying a logical 0 to the C input of OR gate 322. The Q output signal is thus fed back through the D input of OR gate 322 to NAND gate 321. AND gates AND1 and AND2 and OR gate OR1 of Fig. 2A are achieved (according to DeMorgan's theorem) by configuring second combinational stage 330 as a NAND gate.

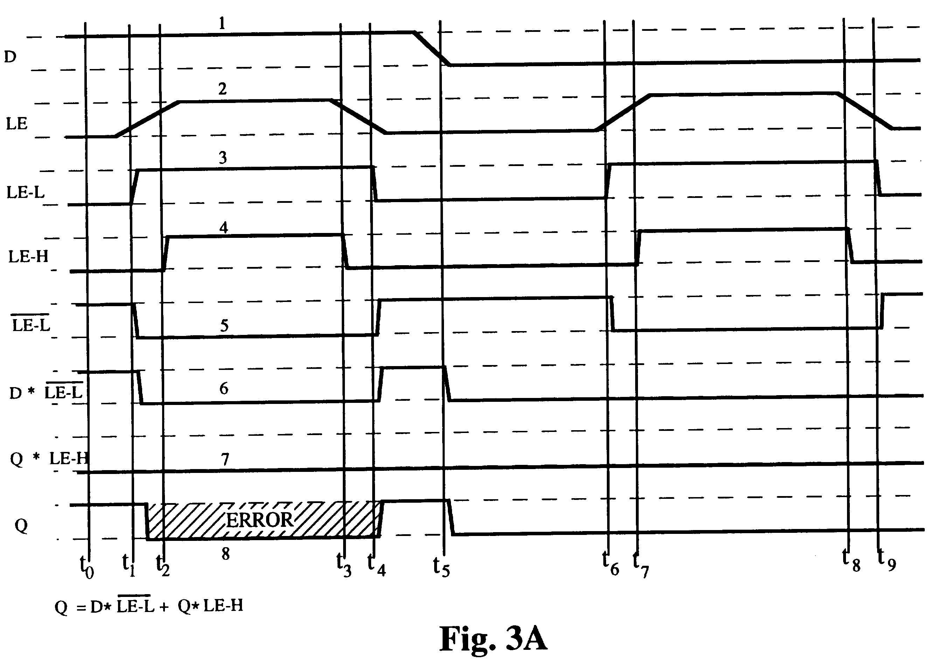

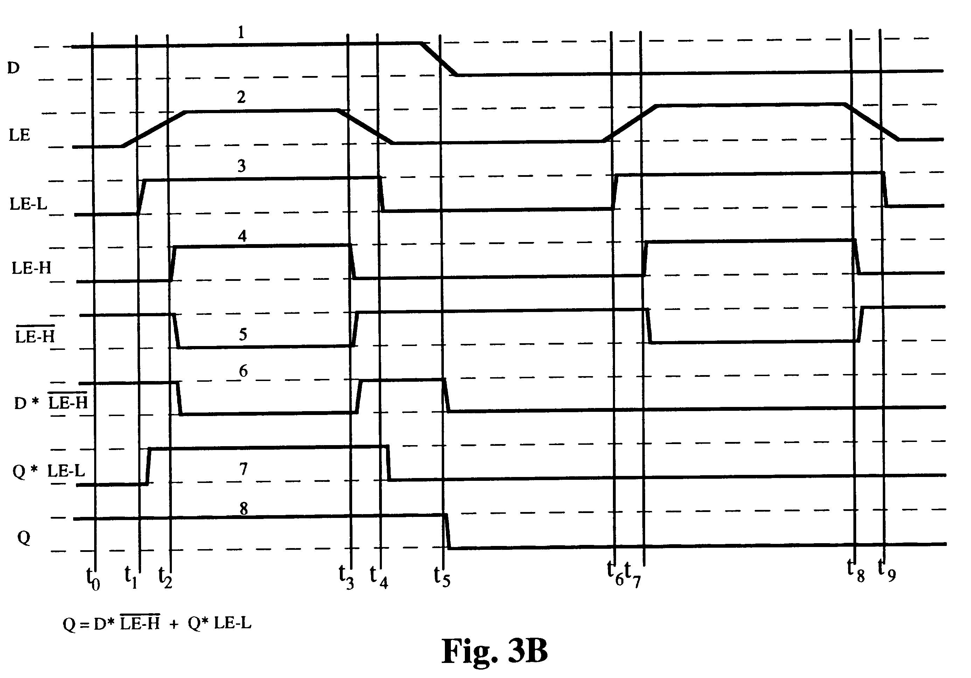

A problem called the static ones hazard can occur with a latch of this logic structure when the circuit is entering the latch mode. The problem can be understood more clearly in conjunction with Figs. 2A through 2C, 3A, and 3B. Depending upon the particular transistors used to implement the gates of Fig. 2B, a transition of latch enable signal LE from low to high may cause a logical zero to be latched when a logical one was present on the data input line. This occurs because a rising LE signal can cause logical zero signals to appear simultaneously (albeit only momentarily) on inputs to both of NAND gates 311 and 321. If these logical 0 signals appear simultaneously at NAND gate 330, a logical 1 data signal will be latched as a logical 0, causing an error. Such an error must be avoided of course, and this can be assured in the circuit of Fig. 1 (Fig. 2B) by controlling trip points in optional inverter 302 and the trip point of NAND gate 321.

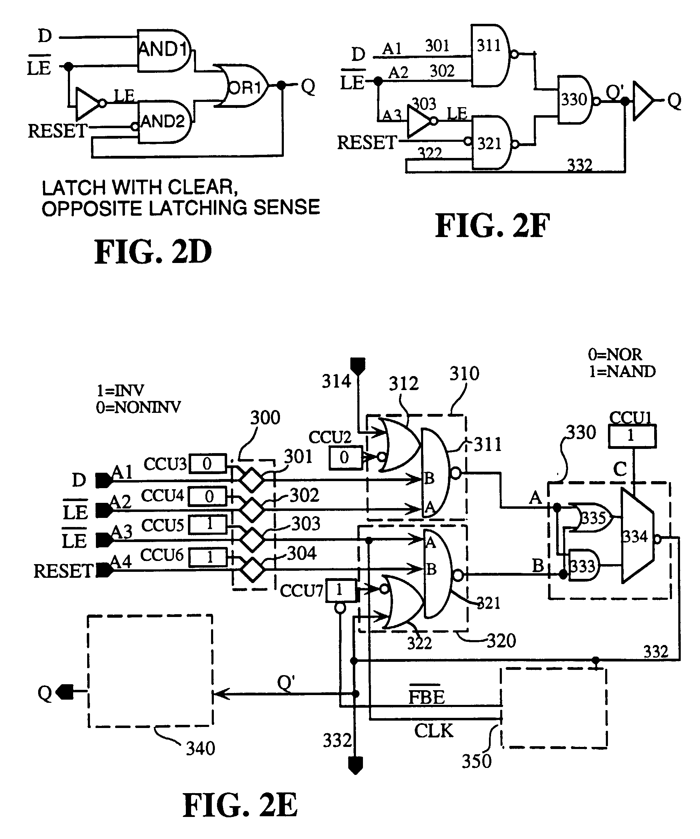

Fig. 2D illustrates a latch with clear in which the latch enable signal LE has the opposite polarity of that in Fig. 2A. Both polarities are needed when sequential latches are needed, for example in a flip flop. Fig. 2E shows the implementation of the latch of Fig. 2D in the Fig. 1 circuit, and Fig. 2F shows the equivalent circuit which results. Optional inverter 302 is configured to pass the LE signal through to the A input of NAND gate 311 and optional inverter 303 is configured as an inverter, passing the complement of A3 to the A input of NAND gate 321.

Figs. 3A and 3B show two different timing diagrams which can result from the circuit of Fig. 2C. The timing diagram of Fig. 3A has a break-before-make characteristic, which exhibits the static ones problem. The timing diagram of Fig. 3B has a make-before-break characteristic, which avoids the static ones problem. By manufacturing optional inverters 302 and 303 of Fig. 1 to have higher trip points than trip points of NAND gates 311 and 321, the timing diagram of Fig. 2B is achieved and the static one's hazard is avoided. Figs. 2A and 2B are now explained.

In the circuit of Figs. 2A through 2C, the input signals are the data input signal D and the latch enable signal LE. (Figs. 3A and 3B may also represent the timing diagrams for the master portion of a D or JK flip flop). As shown in Figs. 3A and 3B, at time $t_0$, the D input is logical 1 and the latch enable signal LE is low, so that the D input signal is being passed through to the Q output. Shortly before time $t_1$, latch enable signal LE begins to go high. Because this signal comes from the interconnect structure, which has some capacitance and resistance, latch enable signal LE is shown as having a gradual rise to logical 1. The description which follows also applies to a latch enable signal which switches quickly with respect to the switching time of inverters and NAND gates within the cell. This LE signal is applied to optional inverter 302 which passes the inverted $\overline{\text{LE}}$ signal to input A of NAND gate 311. Optional inverter 303 is set to be noninverting and thus passes the LE signal to NAND gate 321. In Fig. 3A, curve 3, labeled LE-L, shows how the LE signal is interpreted if the element (inverter or NAND gate) receiving the signal has a low trip point, and curve 4, labeled LE-H, shows how the LE signal is interpreted if the element receiving the signal has a high trip point.

In the case of Fig. 3A, inverter 302 has a relatively low trip point and NAND gate 321 has a relatively high trip point. A static ones' error is shown to occur. Curve 5 represents $\overline{\text{LE-L}}$; the output of optional inverter 302 begins going low at time $t_1$ because optional inverter 302 is assumed to have a low trip point. Curve 6 represents the AND1 output of Fig. 9A, the complement of which is calculated in the implementation of Figs. 9B and 9C by NAND gate 311. Curve 7, which represents the AND2 output signal, the complement of which is generated by NAND gate 321, responds to the signal LE, which was low at time to. Since NAND gate 321 has a relatively high trip point, curve 7 doesn't go high at time $t_1$. Since $D*\overline{\text{LE-L}}$ goes low before LE-H goes high, the logical 1 value on D is lost before it is latched as the Q output, and a logical 0 is erroneously latched as Q from a time after $t_1$ to a time after $t_4$.

In the case of Fig. 3B, inverter 302 has a higher trip point and NAND gate 311 has a lower trip point. Curve 5 shows the $\overline{\text{LE-H}}$ output signal of optional inverter 302 when manufactured to have a high trip point. Curve 6 shows the AND1 signal $D*\overline{\text{LE-H}}$, the complement of which is generated by NAND gate 311. Curve 7 shows the AND2 output function $Q*\text{LEL}$, the complement of which is generated by NAND gate 321. Finally, curve 8 shows the Q output function over the time interval to through $t_9$. The Q output signal is seen to properly follow the D input signal through the positive and negative shifts of the D and LE signals. This is because the LE-L and $\overline{\text{LE-H}}$ signals are never low at the same time. This ensures one of the two NAND gates 311 or 321 will be allowed to propagate its input at all times, thereby providing the needed make-before-break characteristic.

Other embodiments of the invention will become obvious to those skilled in the art in light of the above description.

**Claims**

1. A transparent latch comprising:

   a data input section (310) which receives a data input signal (D) and a first internal clock signal, and generates a data output signal;
   a feedback section (320) which receives a feedback input signal and a second internal clock signal, and generates a feedback output signal; and
   an output section (330) which generates an output signal from signals provided by said data input section (310) and said feedback section (320), said output signal serving as said feedback signal;

   characterised by

   a programmable input inverter stage (300) comprising:
   a first optional inverter (302) for receiving an external clock signal (LE; $\overline{\text{LE}}$) and providing said first internal clock signal, and being either configured to pass the said external clock signal (LE; $\overline{\text{LE}}$) through to said data input section (310) or configured as an inverter passing the complement of said external clock signal (LE; $\overline{\text{LE}}$) to said data input section (310); and
   a second optional inverter (303) for receiving said external clock signal (LE; $\overline{\text{LE}}$) and providing said second internal clock signal, and being either configured to pass the said external clock signal (LE; $\overline{\text{LE}}$) through to said feedback section (320) or configured as an inverter passing the complement of said external clock signal (LE; $\overline{\text{LE}}$) to said feedback section (320);
   said programmable input inverter stage (300) being programmable such that one of said first and second optional inverters (302, 303) is configured as an inverter and the other of said first and second optional inverters (302, 303) is configured to pass said external clock signal through;
   said first and second optional inverters (302, 303) having a first trip point, and said data input section (310) and said feedback section (320) comprising logic gates having a second trip point lower than said first trip point.

2. A transparent latch as in claim 1 in which:

   said data input section comprises a two-input AND gate, one input receiving said data input signal and the other input receiving said first internal clock signal; and
   said feedback section comprises a two-input AND gate, one input receiving said feedback input signal and the other receiving said second internal clock signal.

3. A transparent latch as in claim 2 in which said output section comprises a programmable AND/OR gate programmable to provide one of an AND function and an OR function, said programmable AND/OR gate programmed to provide said OR function.

**Patentansprüche**

1. Transparenter Signalspeicher, umfassend:

   einen Dateneingangsteil (310), der ein Dateneingangssignal (D) und ein erstes internes Taktsignal empfängt und ein Datenausgangssignal generiert;
   einen Rückführungsteil (320), der ein Rückführungseingangssignal und ein zweites internes Taktsignal empfängt und ein Rückführungsausgangssignal generiert; und
   einen Ausgangsteil (330), der ein Ausgangssignal aus Signalen generiert, die von dem genannten Dateneingangsteil (310) und dem genannten Rückführungsteil (320) bereitgestellt werden, wobei das genannte Ausgangssignal als das genannte Rückführungssignal dient; gekennzeichnet durch
   eine programmierbare Eingangsinverterstufe (300), umfassend:
   einen ersten wahlfreien Inverter (302) zum Empfangen eines externen Taktsignals (LE; LE) und zum Bereitstellen des genannten ersten internen Taktsignals, wobei der Inverter entweder so konfiguriert ist, daß er das genannte externe Taktsignal (LE; LE) zu dem genannten Dateneingangsteil (310) durchläßt, oder als Inverter konfiguriert ist, der das Komplement des genannten externen Taktsignals (LE; LE) zu dem genannten Dateneingangsteil (310) durchläßt; und
   einen zweiten wahlfreien Inverter (303) zum Empfangen des genannten externen Taktsignals (LE; LE) und zum Bereitstellen des genannten zweiten internen Taktsignals, wobei der Inverter entweder so konfiguriert ist, daß er das genannte externe Taktsignal (LE; LE) zu dem genannten Rückführungsteil (320) durchläßt, oder als Inverter konfiguriert ist, der das Komplement des genannten externen Taktsignals (LE; LE) zu dem genannten Rückführungsteil (320) durchläßt;
   wobei die genannte programmierbare Eingangsinverterstufe (300) so programmierbar ist, daß der genannte erste oder der genannte zweite wahlfreie Inverter (302, 303) als Inverter und der jeweils andere der beiden wahlfreien Inverter (302 bzw. 303) so konfiguriert ist, daß er das genannte externe Taktsignal durchläßt;
   wobei der genannte erste und der genannte zweite wahlfreie Inverter (302, 303) einen ersten Auslösepunkt haben, und wobei der genannte Dateneingangsteil (310) und der genannte Rückführungsteil (320) logische Gates mit einem zweiten Auslösepunkt hat, der niedriger ist als der genannte erste Auslösepunkt.

2. Transparenter Signalspeicher nach Anspruch 1, bei dem

   der genannte Dateneingangsteil ein AND-Gate mit zwei Eingängen aufweist, wobei ein Eingang das genannte Dateneingangssignal und der andere Eingang das genannte erste interne Taktsignal empfängt; und
   der genannte Rückführungsteil ein AND-Gate mit zwei Eingängen aufweist, wobei ein Eingang das genannte Rückführungseingangssignal und der andere das genannte zweite interne Taktsignal empfängt.

3. Transparenter Signalspeicher nach Anspruch 2, bei dem der genannte Ausgangsteil ein programmierbares AND/OR-Gate aufweist, das so programmierbar ist, daß es entweder eine AND-Funktion oder einer OR-Funktion bereitstellt, wobei das genannte programmierbare AND/OR-Gate so programmiert ist, daß es die genannte OR-Funktion bereitstellt.

**Revendications**

1. Verrou transparent comprenant:

   une section d'entrée de données (310) qui reçoit un signal d'entrée de données (D) et un premier signal d'horloge interne, et génère un signal de sortie de données;
   une section de contre-réaction (320) qui reçoit un signal d'entrée de contre-réaction et un deuxième signal d'horloge interne, et génère un signal de sortie de contre-réaction; et
   une section de sortie (330) qui génère un signal de sortie à partir de signaux fournis par ladite section d'entrée de données (310) et ladite section de contre-réaction (320), ledit signal de sortie servant de dit signal de contre-réaction;

caractérisé par

un étage inverseur d'entrée programmable (300) comprenant:
un premier inverseur optionnel (302) pour recevoir un signal d'horloge externe (LE; $\overline{LE}$) et fournir ledit premier signal d'horloge interne, et étant soit configuré pour passer ledit signal d'horloge externe (LE; $\overline{LE}$) à ladite section d'entrée de données (310) soit configuré comme inverseur passant le complément dudit signal d'horloge externe (LE; $\overline{LE}$) à ladite section d'entrée de données (310); et
un deuxième inverseur optionnel (303) pour recevoir ledit signal d'horloge externe (LE; $\overline{LE}$) et fournir ledit deuxième signal d'horloge interne, et étant soit configuré pour passer ledit signal d'horloge externe (LE; $\overline{LE}$) à ladite section de contre-réaction (320) soit configuré comme inverseur passant le complément dudit signal d'horloge externe (LE; $\overline{LE}$) à ladite section de contre-réaction (320);
ledit étage inverseur d'entrée programmable (300) étant programmable de telle sorte que l'un desdits premier et deuxième inverseurs optionnels (302, 303) est configuré comme inverseur et l'autre desdits premier et deuxième inverseurs optionnels (302, 303) est configuré pour passer ledit signal d'horloge externe;
lesdits premier et deuxième inverseurs optionnels (302, 303) ayant un premier point de déclenchement, et ladite section d'entrée de données (310) et ladite section de contre-réaction (320) comprenant des portes logiques ayant un deuxième point de déclenchement inférieur audit premier point de déclenchement.

2. Verrou transparent tel que revendiqué à la revendication 1, dans lequel:

ladite section d'entrée de données comprend une porte ET à deux entrées, une entrée recevant ledit signal d'entrée de données et l'autre entrée recevant ledit premier signal d'horloge interne; et
ladite section de contre-réaction comprend une porte ET à deux entrées, une entrée recevant ledit signal d'entrée de contre-réaction et l'autre recevant ledit deuxième signal d'horloge interne.

3. Verrou transparent tel que revendiqué à la revendication 2, dans lequel ladite section de sortie comprend une porte ET/OU programmable pour fournir l'une d'une fonction ET et d'une fonction OU, ladite porte ET/OU programmable étant programmée pour fournir ladite fonction OU.

FIG. 1

7

LATCH WITH CLEAR

# FIG. 2A

# FIG. 2C

# FIG. 2B

LATCH WITH CLEAR,
OPPOSITE LATCHING SENSE

**FIG. 2D**

**FIG. 2F**

**FIG. 2E**

**Fig. 3A**

$Q = D * \overline{\text{LE-L}} + Q * \text{LE-H}$

D

LE

LE-L

LE-H

$\overline{\text{LE-L}}$

$D * \overline{\text{LE-L}}$

$Q * \text{LE-H}$

Q

ERROR

$t_0$ $t_1$ $t_2$ $t_3$ $t_4$ $t_5$ $t_6$ $t_7$ $t_8$ $t_9$

1 2 3 4 5 6 7 8

10

Fig. 3B

$$Q = D * \overline{LE\text{-}H} + Q * LE\text{-}L$$